Europäisches Patentamt

European Patent Office

Office européen des brevets

(19)

(11) **EP 0 850 511 B1**

(12) **EUROPÄISCHE PATENTSCHRIFT**

(45) Veröffentlichungstag und Bekanntmachung des Hinweises auf die Patenterteilung:
   **20.06.2001 Patentblatt 2001/25**

(21) Anmeldenummer: **96929321.6**

(22) Anmeldetag: **24.08.1996**

(51) Int Cl.⁷: $H03L\ 7/197$, $H04L\ 27/26$

(86) Internationale Anmeldenummer:
   **PCT/EP96/03742**

(87) Internationale Veröffentlichungsnummer:
   **WO 97/10647 (20.03.1997 Gazette 1997/13)**

(54) **ÜBERTRAGUNGSVERFAHREN, IN DEM EIN UMSETZUNGSOSZILLATORSIGNAL MITTELS EINER FRACTIONAL-N-PHASENREGELSCHLEIFE SYNTHETISIERT WIRD**

TRANSMISSION PROCESS IN WHICH A CONVERSION OSCILLATOR SIGNAL IS SYNTHESISED BY MEANS OF A FRACTIONAL N-PHASE-SHIFT CONTROL LOOP

PROCEDE DE TRANSMISSION DANS LEQUEL UN SIGNAL D'OSCILLATEUR DE CONVERSION EST SYNTHETISE AU MOYEN D'UNE BOUCLE D'ASSERVISSEMENT A N-DEPHASAGE FRACTIONNAIRE

(84) Benannte Vertragsstaaten:
   **DE FR GB IT NL**

(30) Priorität: **16.09.1995 DE 19534462**

(43) Veröffentlichungstag der Anmeldung:
   **01.07.1998 Patentblatt 1998/27**

(73) Patentinhaber:
   • **ATMEL Germany GmbH**
    **74072 Heilbronn (DE)**
   • **ROBERT BOSCH GmbH**
    **70469 Stuttgart (DE)**

(72) Erfinder:
   • **KLING, Helmut**
    **D-89275 Elchingen (DE)**
   • **BOLLE, Michael**
    **D-31139 Hildesheim (DE)**

(74) Vertreter: **Maute, Hans-Jürgen, Dipl.-Ing.**
    **Daimler-Benz Aktiengesellschaft,**
    **FTP/H,**
    **Postfach 35 35**
    **74025 Heilbronn (DE)**

(56) Entgegenhaltungen:
   **WO-A-91/16759      WO-A-95/19671**
   **US-A- 4 816 774**

**Beschreibung**

Die Erfindung betrifft ein übertragungsverfahren gemäß dem Oberbegriff des Patentanspruchs 1.

Derartige Verfahren werden üblicherweise in der Rundfunktechnik zur Übertragung von Rundfunksignalen eingesetzt. Ein aus einem Eingangssignal gebildetes moduliertes Übertragungssignal wird dabei zu einer Empfangseinheit übertragen und durch diese in ein Ausgangssignal umgesetzt. In der Empfangseinheit wird dabei eine Frequenzumsetzung des Übertragungssignals mit einer Oszillatorfrequenz eines Oszillatorsignales vorgenommen. Die Qualität des Ausgangssignal, d. h. die durch die Signalübertragung bedingte Verfälschung des Ausgangssignals gegenüber dem Eingangssignal, hängt dabei in wesentlichem Maße von Phasenrauschbeiträgen des Oszillatorsignals ab. Mit einer Oszillatoreinheit hoher Güte, beispielsweise mit einem Quarzoszillator, läßt sich zwar ein Oszillatorsignal mit geringen Phasenrauschbeiträgen erzeugen, die Oszillatorfrequenz dieses Oszillatorsignals ist jedoch nicht zwischen verschiedenen Werten umschaltbar, so daß mit der Empfangseinheit und mit einer derartigen Oszillatoreinheit keine Kanalauswahl durchführbar ist.

Eine gebräuchliche Methode zur Generierung eines Oszillatorsignals, dessen Oszillatorfrequenz zwischen verschieden Werten eines Frequenzrasters umschaltbar ist, ist die Verwendung einer Phasenregelschleife. Hierbei wird die Oszillatorfrequenz aus einer Referenzfrequenz eines phasenrauscharmen Referenzsignals abgeleitet. Die Oszillatorfrequenz kann dabei in Frequenzschritten, die gleich einem Vielfachen der Referenzfrequenz sind, umgeschaltet werden. Trotz der Verwendung eines rauscharmen Referenzsignal erhält man als Oszillatorsignal ein mit Phasenrauschbeiträgen behaftetes Signal. Diese von der Phasenregelschleife herrührende Phasenrauschbeiträge müssen, da sie sich auf das Ausgangssignal störend auswirken, gering gehalten werden. Durch diese Forderung, die durch die Wahl einer hohen Referenzfrequenz erfüllt werden kann, wird der Einsatzbereich der Phasenregelschleife eingeschränkt, da die Oszillatorfrequenz bei einem Betrieb mit einer hohen Referenzfrequenz nur in großen Frequenzschritten umgeschaltet werden kann.

Aus der WO 91 16759 ist eine Phasenregelschleife bekannt, die auch beim Betrieb mit hoher Referenzfrequenz eine Umschaltung der Oszillatorfrequenz in geringen Frequenzschritten erlaubt. Diese Phasenregelschleife weist im Rückkopplungszweig einen Frequenzteiler auf, dessen Teilerverhältnis zwischen verschiedenen Werten umschaltbar ist. Durch die Umschaltung läßt sich der zeitliche Mittelwert des Teilerverhältnisses auf nicht-ganzzahlige Werte einstellen, so daß die Oszillatorfrequenz in Bruchteilen der Referenzfrequenz umschaltbar ist. Eine derartige Phasenregelschleife wird daher üblicherweise als fractional-N-Phasenregelschleife bezeichnet. Als nachteilig erweist sich hierbei, daß durch das regelmäßige Umschalten des Teilerverhältnisses Störlinien in das Frequenzspektrum des Oszillatorsignals eingekoppelt werden. Diese Störlinien lassen sich, da eine Filterung die Einschwingzeit der Phasenregelschleife ungünstig beeinflussen würde, nur durch aufwendige Maßnahmen reduzieren.

Der Erfindung liegt daher die Aufgabe zugrunde, ein Verfahren gemäß dem Oberbegriff des Patentanspruchs 1 anzugeben, das einfach und kostengünstig realisierbar ist, mit dem die Oszillatorfrequenz des Oszillatorsignals schnell zwischen verschiedenen Werten umgeschaltet werden kann und mit dem ein für das Ausgangssignal günstiges Phasenrauschverhalten des Oszillatorsignals erreicht wird.

Die Aufgabe wird durch die Merkmale des Patentanspruchs 1 gelöst. Vorteilhafte Ausgestaltungen und Weiterbildungen ergeben sich aus den Unteransprüchen.

Erfindungsgemäß wird zur Umsetzung des Übertragungssignals in das Ausgangssignal ein Empfangsverfahren verwendet, bei dem Phasenrauschbeiträge aus dem Frequenzspektrum des Oszillatorsignals abhängig von deren Frequenzlage unterschiedlich bewertet werden, d. h., bei dem das Ausgangssignal durch die Phasenrauschbeiträge aus dem Oszillatorsignal in Abhängigkeit von der Frequenzlage dieser Phasenrauschbeiträge unterschiedlich stark gestört wird. Diese Eigenschaft des Empfangsverfahrens wird durch die sog. Phasenrauschgewichtsfunktion, die den Einfluß von spektralen Phasenrauschbeiträgen des Oszillatorsignals auf die Qualität des Ausgangssignals darstellt, beschrieben. Die Phasenrauschgewichtsfunktion ist demzufolge ein Maß für die durch Phasenrauschbeiträge aus dem Oszillatorsignal bedingte Verfälschung des Ausgangssignals. Das Oszillatorsignal wird mittels einer fractional-N-Phasenregelschleife aus einem Referenzsignal mit einer bestimmten Referenzfrequenz synthetisiert, wobei das Verhältnis aus Oszillatorfrequenz des Oszillatorsignals und Referenzfrequenz des Referenzsignals eine rationale Zahl ist, d. h. die Referenzfrequenz ist um einen rationalen Frequenzumsetzfaktor kleiner als die Oszillatorfrequenz. Mit der fractional-N-Phasenregelschleife lassen sich demzufolge Oszillatorfrequenzen aus einem Frequenzraster synthetisieren, dessen Rasterfrequenz um einen ganzzahligen Teilerfaktor kleiner als die Referenzfrequenz ist. Als Rasterfrequenz wird dabei der Frequenzabstand zwischen zwei benachbarten Frequenzen des Frequenzrasters bezeichnet. Aufgrund des rationalen Frequenzumsetzfaktors weist das Oszillatorsignal ein Frequenzspektrum mit mehreren Störlinien auf, deren Frequenzlage durch die Rasterfrequenz festgelegt wird. Erfindungsgemäß werden diese Störlinien, die Phasenrauschbeiträge aus dem Oszillatorsignal darstellen, durch eine geeignete Wahl der Rasterfrequenz in Frequenzbereiche gelegt, wo sie aufgrund der Frequenzabhängigkeit der Phasenrauschgewichtsfunktion das Ausgangssignal nicht oder nur unwesentlich stören.

Als Empfangsverfahren wird ein Verfahren verwendet, bei dem die Phasenrauschgewichtsfunktion mehrere Nullstellen, d. h. Frequenzen, bei denen der Wert der Phasenrauschgewichtsfunktion 0 ist, aufweist, von denen zumindest einige in einem bestimmten Nullstellenfrequenzraster liegen. Die Rasterfrequenz wird vorzugsweise so gewählt, daß die Störlinien aus dem Frequenzspektrum des 0szillatorsignals mit Nullstellen der Phasenrauschgewichtsfunktion zusammenfallen.

Die Empfangseinheit und die fractional-N-Phasenregelschleife sind, da sie integrierbar und einfach und kostengünstig realisierbar sind, bestens für den Einsatz in Rundfunkgeräten eines beispielsweise aus der Druckschrift "European Telecommunication Standard ETS 300 401" bekannten digitalen Rundfunksystems (DAB, Digital Audio Broadcasting) geeignet. Bei diesem Rundfunksystem wird als Übertragungsverfahren das sog. COFDM-(Coded Orthogonal Frequency Division Multiplex-) Verfahren verwendet. Es handelt sich hierbei um ein Mehrträgerverfahren, bei dem das Übertragungssignal als Mehrträgersignal mit einer Vielzahl äquidistanter Unterträger zur Empfangseinheit übertragen wird. Die Umsetzung der Übertragungssignale in die Ausgangssignale führt bei diesem Rundfunksystem zu der oben beschriebenen Phasenrauschgewichtsfunktion.

Die Erfindung wird im folgenden anhand der Figuren näher beschrieben. Es zeigen:

Figur 1    ein Prinzipschaltbild eines digitalen Rundfunksystems als Ausführungsbeispiel eines Systems zur Durchführung des erfindungsgemäßen Verfahrens,

Figur 2    ein Frequenzspektrum eines von einer fractional-N-Phasenregelschleife aus Figur 1 gelieferten Oszillatorsignals und

Figur 3    eine Phasenrauschgewichtsfunktion einer Empfangseinheit aus Figur 1.

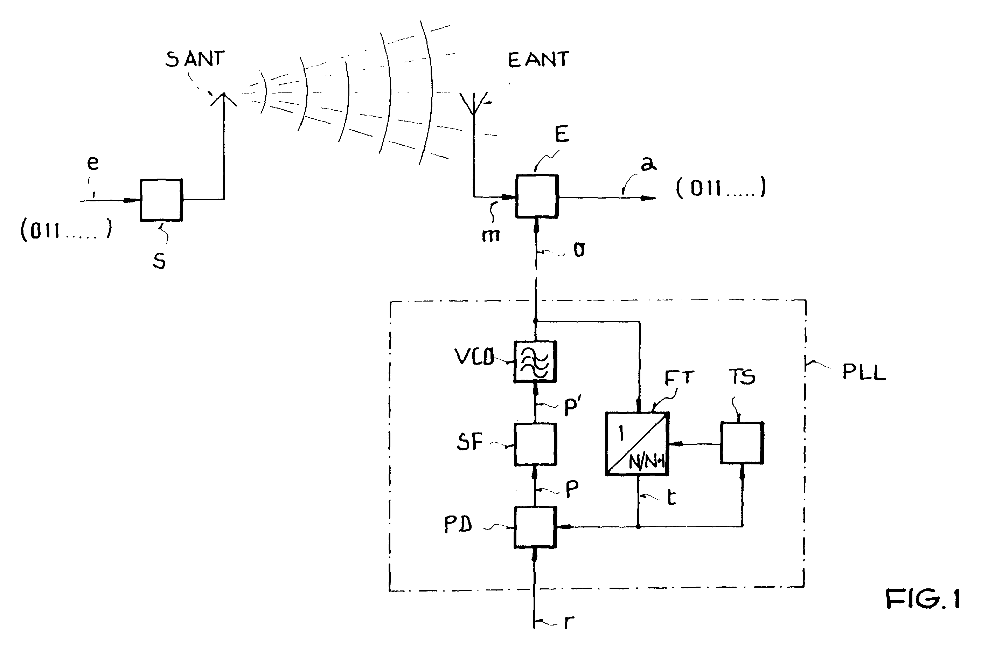

Gemäß der Figur 1 wird ein digitales Signal als Eingangssignal e der Sendeeinheit S zugeführt, die es mit dem COFDM- oder OFDM- (Orthogonal-Frequency-Division-Multiplex-)Verfahren in das Übertragungssignal m umsetzt. Dabei wird das Eingangssignal e codiert, moduliert und frequenzumgesetzt und man erhält als Übertragungssignal m ein Mehrträgersignal mit mehreren in einem Übertragungsfrequenzraster liegenden Unterträgern.

Das Übertragungssignal m wird über die Sendeantenne SANT der Sendeeinheit S zur Empfangsantenne EANT der Empfangseinheit E übertragen und durch diese gemäß dem OFDM- oder COFDM-Verfahren in das Ausgangssignal a umgesetzt. Das Übertragungssignal m wird dabei mit dem Oszillatorsignal o frequenzumgesetzt. Durch anschließende Signalverarbeitung erhält man dann als Ausgangssignal a ein digitales Signal, das bei fehlerfreier Übertragung gleich dem Eingangssignal e ist.

Das Oszillatorsignal o wird mittels der fractional-N-Phasenregelschleife PLL aus dem Referenzsignal r erzeugt. Diese fractional-N-Phasenregelschleife PLL setzt sich aus dem Phasendetektor PD, dem Schleifenfilter SF, dem spannungsgesteuerten Oszillator VCO, dem Frequenzteiler FT und der Teilersteuereinheit TS zusammen. Der Phasendetektor PD vergleicht dabei das Referenzsignal r mit einem mit dem Frequenzteiler FT durch Frequenzteilung aus dem Oszillatorsignal o gebildeten Teilersignal t und liefert ein von der Phasendifferenz dieser beiden Signale abhängiges Regelsignal p, welches über das als Tiefpaßfilter ausgeführte Schleifenfilter SF als geglättetes Regelsignal p' dem spannungsgesteuerten Oszillator VCO zugeführt wird. Die Frequenz des vom spannungsgesteuerten Oszillator VCO gelieferten Oszillatorsignals o - die Oszillatorfrequenz $f_o$ - wird dabei aufgrund der Rückkopplung über den Frequenzteiler FT auf einen zur Frequenz des Referenzsignals r - der Referenzfrequenz $f_r$ - proportionalen Wert eingestellt. Für die Oszillatorfrequenz $f_o$ gilt somit die Beziehung $f_o = f_r \cdot F$, wobei F den Frequenzumsetzfaktor der fractional-N-Phasenregelschleife PLL darstellt. Dieser Frequenzumsetzfaktor F ist eine rationale Zahl, d. h. eine Bruchzahl, die man dadurch erhält, daß das Teilerverhältnis des Frequenzteilers FT, durch die Teilersteuereinheit TS gesteuert, zwischen zwei ganzzahligen Werten, beispielsweise zwischen einem ersten Wert N und einem um 1 größeren zweiten Wert N+1, in geeigneter Weise umgeschaltet wird. Er kann in der Form F = N+K/M angegeben werden, wobei N den Ganzteil und K/M den Bruchteil des Frequenzumsetzfaktors F darstellt. Die Oszillatorfrequenz $f_o$ läßt sich demnach zwischen Werten, die um eine Rasterfrequenz $f_d$ oder um ein ganzzahliges Vielfaches der Rasterfrequenz $f_d$ voneinander beabstandet sind, umschalten, wobei die Rasterfrequenz $f_d$ um den ganzzahligen Teilerfaktor M kleiner als die Referenzfrequenz $f_r$ ist. Der Zähler K des Bruchteils K/M gibt an wievielmal während M Frequenzteilungen eine Frequenzteilung durch den ersten Wert N und wie oft eine Frequenzteilung durch den zweiten Wert N+1 durchgeführt wird. Für den Ganzteil N, für den Zähler K des Bruchteils K/M und für den Teilerfaktor M, die alle ganzzahligen Werte annehmen, gelten dabei die folgenden Bedingungen:

$$N \geq 1, M \geq 2, M > K \geq 0.$$

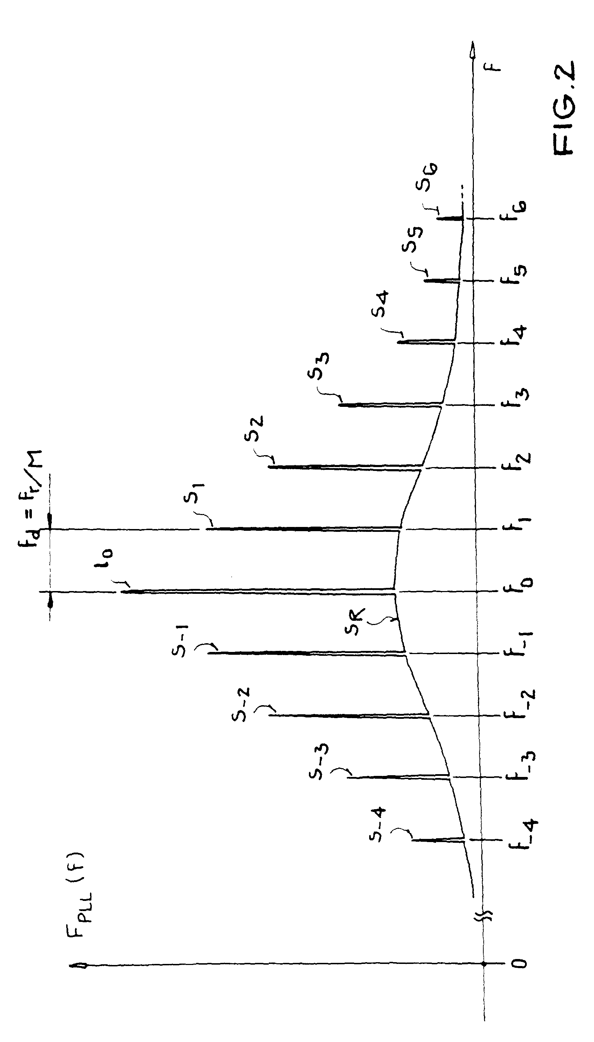

Gemäß der Figur 2 treten im Frequenzspektrum $F_{PLL}(f)$ des Oszillatorsignals o die Störlinien $s_{-4} \ldots s_6$ auf. Diese Störlinien $s_{-4} \ldots s_6$, die im Frequenzraster des Oszillatorsignals o liegen, d. h. deren Frequenzen $f_{-4} \ldots f_6$ um

ganzzahlige Vielfache der Rasterfrequenz $f_d$ von der Oszillatorfrequenz $f_o$ beabstandet sind, und die verglichen mit der bei der Oszillatorfrequenz $f_o$ liegenden Nutzsignallinie $l_o$ besonders hohe, dem Grundrauschen $s_R$ des Oszillatorsignals o überlagerte Phasenrauschbeiträge darstellen, können das Ausgangssignal a stark verfälschen. Obwohl die Amplitude der Störlinien $s_{-4}$ ... $s_6$ durch die Wahl einer geringen Schleifenbandbreite des Schleifenfilters SF reduziert werden kann, wird diese Maßnahme im vorliegenden Beispiel nicht getroffen, da hierdurch das Grundrauschen $s_R$ des Oszillatorsignals o in bestimmten Frequenzbereichen ungünstig angehoben werden würde.

Die Abhängigkeit des Ausgangssignals a von Phasenrauschbeiträgen läßt sich mit einer Phasenrauschgewichtsfunktion H(f), die den Einfluß der spektralen Phasenrauschbeiträge des Oszillatorsignals o auf die Qualität des Ausgangssignals a, z. B. auf die Bitfehlerrate - d. h. auf die Anzahl von fehlerhaften Bitstellen des Ausgangssignals a bezogen auf die Anzahl der übertragenen Bitstellen - darstellt, beschreiben.

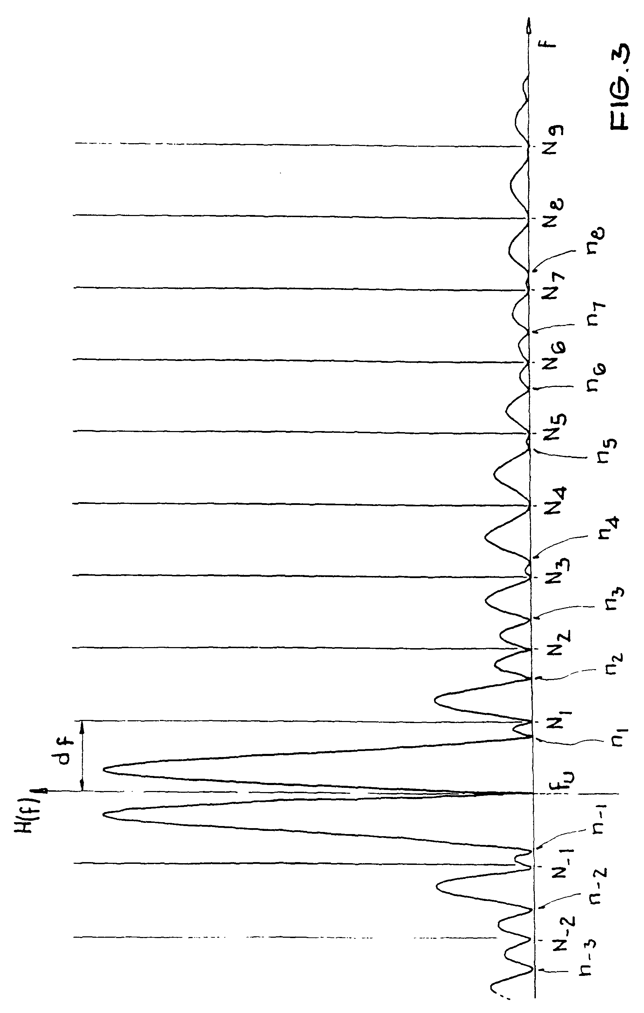

Die Figur 3 zeigt die Phasenrauschgewichtsfunktion H(f) der Empfangseinheit E, die man beim verwendeten Empfangsverfahren für einen Unterträger des Übertragungssignals m erhält. Ihr Betrag kann in der folgenden Form angegeben werden:

$$\left\| H(f) \right\| = \left\| 2 \cdot \frac{\sin(\pi(f\text{-}f_u) \cdot N_{FFT}/f_c)}{N_{FFT} \cdot \sin(\pi \cdot (f\text{-}f_u)/f_c)} \cdot \sin(\pi \cdot (f\text{-}f_u) \cdot (N_{FFT}/f_c + D)) \right\|$$

Dabei wird mit f die Frequenz des betrachteten Phasenrauschbeitrags, mit $f_u$ die Frequenz des betrachteten Unterträgers, mit $f_c$ die Abtastrate einer im Anschluß an die Frequenzumsetzung in der Empfangseinheit E durchgeführten Abtastung, mit $N_{FFT}$ die Anzahl von Abtastwerten, mit denen nach der Abtastung in der Empfangseinheit E eine Fast-Fourier-Transformation durchgeführt wird, und mit D eine Schutzintervallzeit bezeichnet. Als Zahlenwerte kann man beispielsweise $f_c$ = 2,048 MHz, $N_{FFT}$ = 2048, D = 246 us oder $f_c$ = 2,048 MHz, $N_{FFT}$ = 512 und D = 61,5 µs wählen.

Die zur Frequenz $f_u$ des Unterträgers symetrische Phasenrauschgewichtsfunktion H(f) weist eine Vielzahl von Nullstellen $n_{-3}$ ... $n_8$, $N_{-2}$ ... $N_9$ auf, von denen die Nullstellen $N_{-2}$ ... $N_9$ um ein ganzzahliges Vielfaches der Differenzfrequenz $d_f$ = $f_c/N_{FFT}$ größer oder kleiner als die Frequenz $f_u$ des Unterträgers sind, d. h. die Nullstellen $N_{-2}$ ... $N_9$ liegen in einem Nullstellenfrequenzraster.

Die Phasenrauschgewichtsfunktion H(f) besagt, daß eine in einer der Nullstellen $N_{-2}$ ... $N_9$ liegende Störlinie $s_{-4}$ ... $s_6$, die als Phasenrauschbeitrag dem Grundrauschen $s_R$ des Oszillatorsignals o überlagert ist, durch das Empfangsverfahren, d. h. durch die Empfangseinheit E, nicht bewertet wird und somit keine Verfälschung des Ausgangssignals a bewirkt. Um den Einfluß der Störlinien $s_{-4}$ ... $s_6$ aus dem Frequenzspektrum $F_{PLL}(f)$ auf das Ausgangssignal a zu minimieren, wird das Frequenzraster des Oszillatorsignals o durch eine geeignete Wahl der Rasterfrequenz $f_d$, d. h. durch eine geeignete Wahl der Referenzfrequenz $f_r$ und des Teilerfaktors M, derart eingestellt, daß die Frequenzen $f_{-4}$ ... $f_{-1}$, $f_1$ ... $f_6$ der Störlinien $s_{-4}$ ... $s_6$ mit einigen der Nullstellen $N_{-2}$ ... $N_9$ aus dem Nullstellenfrequenzraster der Phasenrauschgewichtsfunktion H(f) zusammenfallen. Dieses läßt sich beispielsweise durch die Wahl von $f_d$ = L · $d_f$ erreichen, wobei L eine ganze Zahl darstellt. Diese Forderung wird beim vorliegenden Beispiel dann erfüllt, wenn die Rasterfrequenz $f_d$ des Oszillatorsignals o gleich einem ganzzahligen Vielfachen des Frequenzabstands zwischen zwei benachbarten Unterträgern des Übertragungssignals m ist. Auf diese Weise wird sichergestellt, daß die Störlinien $s_{-4}$ ... $s_6$ aus dem Frequenzspektrum $F_{PLL}(f)$ des Oszillatorsignals o die Bitfehlerrate nicht oder wegen der in der Praxis immer vorhandenen Frequenzabweichung lediglich in so geringem Maße erhöhen, daß dieses am Ausgangssignal a nicht als störend empfunden wird.

Durch die Wahl einer hohen Referenzfrequenz $f_r$ wird das Grundrauschen $s_R$ des Oszillatorsignals o, insbesondere in dem, im vorliegenden Beispiel durch die Nullstellen $N_{-1}$ und $N_1$ begrenzten, kritischen Bereich der Phasenrauschgewichtsfunktion H(f) gering gehalten.

## Patentansprüche

1. Übertragungsverfahren, bei dem aus einem Eingangssignal (e) ein moduliertes Übertragungssignal (m) gebildet wird, welches zu einer Empfangseinheit (E) übertragen und durch diese in ein Ausgangssignal (a) umgesetzt wird, wobei in der Empfangseinheit (E) eine Frequenzumsetzung mit einer Oszillatorfrequenz ($f_o$) eines Oszillatorsignals (o) vorgenommen wird und das Oszillatorsignal (o) mittels einer fractional-N-Phasenregelschleife (PLL) aus einem Referenzsignal (r) synthetisiert wird, dessen Referenzfrequenz ($f_r$) gleich einem ganzzahligen Vielfachen einer den kleinstmöglichen Frequenzabstand zwischen zwei synthetisierbaren Oszillatorfrequenzen ($f_o$) darstellenden Rasterfrequenz ($f_d$) ist,
dadurch gekennzeichnet,

- daß zur Umsetzung des Übertragungssignals (m) in das Ausgangssignal (a) ein Empfangsverfahren verwendet wird, bei dem eine Phasenrauschgewichtsfunktion (H(f)), die den Einfluß von spektralen Phasenrauschbeiträgen des Oszillatorsignals (o) auf die Qualität des Ausgangssignals (a) darstellt, Nullstellen ($n_{-3}$ ... $n_8$, $N_{-2}$ ... $N_9$) aufweist, von denen zumindest einige in einem bestimmten Nullstellenfrequenzraster liegen,

- und daß die Rasterfrequenz ($f_d$) derart gewählt wird, daß Phasenrauschbeiträge des Oszillatorsignals (o), die als Störlinien ($s_{-4}$ ... $s_6$) im Frequenzspektrum ($F_{PLL}$(f)) des Oszillatorsignals (o) auftreten, in Frequenzbereiche ($N_{-2}$ ... $N_9$) gelegt werden, in denen sie das Ausgangssignal (a) nicht oder nur unwesentlich stören.

2. Verfahren nach Anspruch 1, dadurch gekennzeichnet, daß die Rasterfrequenz ($f_d$) derart gewählt wird, daß die Störlinien ($s_{-4}$ ... $s_6$) aus dem Frequenzspektrum ($F_{PLL}$(f)) des Oszillatorsignals (o) mit zumindest einigen der Nullstellen ($N_{-2}$ ... $N_9$) aus dem Nullstellenfrequenzraster zusammenfallen.

3. Verfahren nach einem der vorherigen Ansprüche, dadurch gekennzeichnet, daß es in einem digitalen Rundfunksystem zur Übertragung von Rundfunksignalen verwendet wird.

4. Verfahren nach einem der vorherigen Ansprüche, dadurch gekennzeichnet, daß das Übertragungssignal (m) als Mehrträgersignal mit mehreren äquidistant beabstandeten Unterträgern zur Empfangseinheit (E) übertragen wird.

5. Verfahren nach Anspruch 4, dadurch gekennzeichnet, daß zur Bildung des Übertragungssignals (m) das sogenannten OFDM-(Orthogonal Frequency Division Multiplex-) oder COFDM-(Coded OFDM-)Verfahren verwendet wird.

6. Verfahren nach Anspruch 4 oder 5, dadurch gekennzeichnet, daß die Rasterfrequenz ($f_d$) des Oszillatorsignals (o) so gewählt wird, daß sie gleich einem ganzzahligen Vielfachen des Frequenzabstandes zwischen zwei benachbarten Unterträgern des Übertragungssignals (m) ist.


**Claims**

1. Transmission process, in which a modulated transmission signal (m) is formed from an input signal (e), which transmission signal is transmitted to a receiving unit (E) and converted thereby into an output signal (a), wherein a frequency conversion with an oscillator frequency ($f_o$) of an oscillator signal (o) is carried out in the receiving unit (E), and the oscillator signal (o) is synthesised by means of a fractional-N-phase-locked loop (PLL) from a reference signal (r), the reference frequency ($f_r$) of which is equal to an integral multiple of a raster frequency ($f_d$) representing the minimum frequency spacing between two synthesisable oscillator frequencies ($f_o$), characterised in

- that, in order to convert the transmission signal (m) into the output signal (a), a receiving process is used in which a phase jitter weighting function (H(f)), which represents the influence of spectral phase jitter contributions of the oscillator signal (o) on the quality of the output signal (a), comprises zero positions ($n_{-3}$ ... $n_8$, $N_{-2}$ ... $N_9$), at least some of which lie in a specified zero position frequency raster,

- and that the raster frequency ($f_d$) is selected such that phase jitter contributions of the oscillator signal (o), which occur as interference lines ($s_{-4}$ ... $S_6$) in the frequency spectrum ($F_{PLL}$(f)) of the oscillator signal (o), are placed in frequency ranges ($N_2$ ... $N_9$) in which they do not interfere with the output signal (a), or only to a negligible degree.

2. Process according to Claim 1, characterised in that the raster frequency ($f_d$) is selected such that the interference lines ($s_{-4}$ ... $s_6$) from the frequency spectrum ($F_{PLL}$(f)) of the oscillator signal (o) coincide with at least some of the zero positions ($N_{-2}$ ... $N_9$) from the zero position frequency raster.

3. Process according to any one of the preceding Claims, characterised in that it is used in a digital broadcast system to transmit broadcast signals.

4. Process according to any one of the preceding Claims, characterised in that the transmission signal (m) is transmitted as a multi-carrier signal with a plurality of equidistantly spaced subcarriers to the receiving unit (E).

**5.** Process according to Claim 4, characterised in that the so-called OFDM-(Orthogonal Frequency Division Multiplex-) or COFDM-(Coded OFDM-) process is used to form the transmission signal (m).

**6.** Process according to Claim 4 or 5, characterised in that the raster frequency ($f_d$) of the oscillator signal (o) is selected such that it is equal to an integral multiple of the frequency spacing between two adjacent subcarriers of the transmission signal (m).

**Revendications**

**1.** Procédé de transmission, selon lequel on forme à partir d'un signal d'entrée (a) un signal de transmission modulé (m), qui est transmis à une unité de réception (E) et est converti par cette dernière en un signal de sortie (a), selon lequel dans l'unité de réception (E) une conversion de fréquence est réalisée avec une fréquence d'oscillateur ($f_o$) d'un signal d'oscillateur (o) et le signal d'oscillateur (o) est synthétisé au moyen d'une boucle de régulation de phase N-fractionnelle (PLL) à partir d'un signal de référence (r), dont la fréquence de référence ($f_r$) est égale à un multiple entier d'une fréquence de trame ($f_d$) qui représente l'écart le plus faible possible en fréquence entre deux fréquences d'oscillateur synthétisables ($f_o$),
caractérisé en ce

- que pour la conversion du signal de transmission (m) en le signal de sortie (a), on utilise un procédé de réception, selon lequel une fonction de poids de bruit de phase (H(f)), qui représente l'influence de composantes spectrales de bruit de phase dans le signal d'oscillateur (o) sur la qualité du signal de sortie (a), possède des points d'annulation ($n_{-3} ... n_{-8}$, $N_{-2} ... N_9$), dont au moins quelques-uns sont situés dans une trame déterminée de fréquences de points d'annulation; et
- que la fréquence de trame (fd) est choisie de telle sorte que des composantes de bruit de phase du signal d'oscillateur (0), qui apparaissent en tant que raies parasites ($s_{-4} ... s_6$) dans le spectre des fréquences ($F_{PLL}$(f)) du signal d'oscillateur (o), sont placées dans des gammes de fréquences ($N_{-2} ... N_9$), dans lesquelles elles ne perturbent pas ou perturbent seulement d'une manière peu importante le signal de sortie (a).

**2.** Procédé selon la revendication 2, caractérisé en ce que la fréquence de trame ($f_d$) est choisie de telle sorte que les raies parasites ($s_{-4} ... s_6$) provenant du spectre de fréquences ($F_{PLL}$(f)) du signal d'oscillateur (o) coïncident avec au moins quelques-uns des points d'annulation ($N_{-2} ... N_9$) tirés de la trame des fréquences de points d'annulation.

**3.** Procédé selon l'une des revendications précédentes, caractérisé en ce qu'il est utilisé dans un système de radiodiffusion numérique pour la transmission de signaux de radiodiffusion.

**4.** Procédé selon l'une des revendications précédentes, caractérisé en ce que le signal de transmission (m) est transmis sous la forme d'un signal à porteuses multiples avec plusieurs sous-porteuses équidistantes, à l'unité de réception (E).

**5.** Procédé selon la revendication 4, caractérisé en ce que pour former le signal de transmission (m), on utilise le procédé dit OFDM (Orthogonal Frequency Division Multiplex, c'est-à-dire procédé de multiplexage à division de fréquence orthogonale) ou le procédé dit COFDM (Coded OFDM, c'est-à-dire procédé OFDM codé).

**6.** Procédé selon la revendication 4 ou 5, caractérisé en ce que la fréquence de trame (fd) du signal d'oscillateur (o) est choisie de telle sorte qu'elle est égale à un multiple entier de l'écart en fréquence entre deux sous-porteuses voisines du signal de transmission (m).

FIG.1

FIG.2

FIG.3